(19) Europäisches Patentamt

European Patent Office

Office européen des brevets

(11) **EP 3 961 525 A1**

(12) **EUROPEAN PATENT APPLICATION**

(43) Date of publication:
**02.03.2022 Bulletin 2022/09**

(51) International Patent Classification (IPC):
**G06Q 10/04** *(2012.01)* **G06Q 30/02** *(2012.01)*

(21) Application number: **20193630.9**

(22) Date of filing: **31.08.2020**

(52) Cooperative Patent Classification (CPC):
**G06Q 10/04; G06Q 30/0201**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Koninklijke Philips N.V.**
**5656 AG Eindhoven (NL)**

(72) Inventors:
- **MOLLUS, Sabine**
  **5656 AE Eindhoven (NL)**
- **SAPORITO, Salvatore**
  **5656 AE Eindhoven (NL)**
- **VALENTI, Giulio**
  **5656 AE Eindhoven (NL)**

(74) Representative: **Philips Intellectual Property & Standards**
**High Tech Campus 52**
**5656 AG Eindhoven (NL)**

(54) **DETERMINING A LEVEL OF INTERACTION EXPERIENCED BY A SUBJECT**

(57) According to an aspect, there is provided a computer-implemented method (300, Fig. 3) for determining a level of interaction experienced by a subject (102). The method includes receiving first location data representing a location of a first device (104a) in relation to one or more reference locations, wherein the first device (104a) is associated with a first subject (102a); obtaining first relative orientation data representing an orientation of the first device (104a) in relation to a facing direction of the first subject (102a); receiving first orientation data representing an orientation of the first device (104a) in relation to a first reference frame; receiving second location data representing a location of a second device (104b) in relation to at least one reference location; receiving second orientation data representing an orientation of the second device (104b) in relation to a second reference frame; determining, based on the obtained relative orientation data and the first orientation data, an indication of an absolute orientation of the first subject (102a) with respect to the first reference frame; and determining, based on the first location data, the second location data, the second orientation data and the indication of the absolute orientation of the first subject (102a), a level of interaction between the first subject (102a) and the second device (104b).

Fig. 1

**Description**

FIELD OF THE INVENTION

The invention relates to determining a location and an orientation of a subject and a device and, more particularly, to determining a level of interaction between the subject and the device, or between a pair of subjects.

BACKGROUND OF THE INVENTION

Assessing a level of interaction experienced by a subject may comprise assessing interactions between a subject and a device, or, similarly, between a pair of subjects, and can be important in a range of scenarios including, for example, a care home setting, a conference, a social event, or the like. An interaction between a subject and a device may include an evaluation of whether, and for how long, the subject interacts with, for example, an electronic kiosk, such as a ticket issuing machine, a vending machine, or the like. Determining an interaction between a subject and a device can yield useful information in a range of scenarios including monitoring how long a subject interacts with a device, such as in a work context, assessing an amount of time spent in front of a screen, or the like. Similarly, an assessment of interactions between a pair of subjects may include, for example, an evaluation of interactions between a professional care giver and a care recipient in a care facility and/or an evaluation of a resident's individual social activity, such as with other residents within the care facility.

Determining a level of interaction between a subject and a device, or a level of interaction between a pair of subjects, can prove challenging in certain circumstances, including, for example, when a number of subjects are interacting with one another within a confined space and/or when the subjects spend a period of time in the vicinity of one another without interacting, or interacting only sporadically.

Social interaction between human beings is an essential component of psychosocial wellness and thus social interactivity is often a key category when assessing nursing homes. Currently, assessment of social interaction may be limited to human observation or to an interview based assessment. It is therefore desirable to improve the assessment of social interactions between subjects; one way this objective may be achieved is by automating the assessment of social interactions which, for example, in a care home setting may allow for improved staff and task planning, care reporting, care assessment and care effort justification, as well as an improved assessment of a resident's individual social activity and the detection of social isolation.

SUMMARY OF THE INVENTION

Determining a level of interaction experienced by a subject, such as a level of interaction between a subject and a device or a level of interaction between a pair of subjects, can become more difficult to quantify as the density of subjects within an area increases. Subjects may be in close proximity to one another and, in some cases, may spend significant periods of their day in close proximity to one another, but do not necessary interact or interact only infrequently. These factors are compounded as the number of subjects within an area increases. It is therefore desirable to provide an improved method for assessing a level of interaction between a subject and a device, or, equivalently, a level of interaction between a pair of subjects, that is capable of distinguishing between subjects and/or devices that are merely in close proximity to one another and those that are interacting with one another. According to various embodiments disclosed herein, methods and systems are provided that are able to assess a level of interaction using, among other things, a combination of proximity-based and orientation-based measurements.

According to a first specific aspect, there is provided a computer-implemented method for determining a level of interaction experienced by a subject. The method comprises receiving first location data indicative of a location of a first device relative to at least one reference location, the first device being positioned about the body of a first subject; obtaining first relative orientation data indicative of an orientation of the first device relative to a facing direction of the first subject; receiving first orientation data indicative of an orientation of the first device relative to a first reference frame; receiving second location data indicative of a location of a second device relative to at least one reference location; receiving second orientation data indicative of an orientation of the second device relative to a second reference frame; determining, based on the obtained relative orientation data and the first orientation data, an indication of an absolute orientation of the first subject with respect to the first reference frame; and determining, based on the first location data, the second location data, the second orientation data and the indication of the absolute orientation of the first subject, a level of interaction between the first subject and the second device.

In some embodiments, the second device may be associated with the body of a second subject. The method may, in some embodiments, further comprise obtaining second relative orientation data indicative of an orientation of the second device relative to a facing direction of the second subject; determining, based on the obtained second relative orientation data and the second orientation data, an indication of an absolute orientation of the second subject with respect to the second reference frame; and determining, based on the first location data, the second location data, the indication of the absolute orientation of the first subject and the indication of the absolute orientation of the second subject, a level of interaction between the first subject and the second subject.

The method may further comprise receiving at least one of image data in respect of at least one of the first subject and the second device, from a camera; and audio data in respect of at least one of the first subject and the second device, from a microphone. Determining the level of interaction may, in some embodiments, be further based on at least one of the image data and the audio data.

In some embodiments, the first location data may be indicative of a location of the first device relative to at least one of: a receiver of a localisation system; and the second device. The second location data may, in some embodiments, be indicative of a location of the second device relative to at least one of: a receiver of the localisation system; and the first device.

In some embodiments, the first relative orientation data may comprise data acquired in respect of an orientation of the first device relative to the facing direction of the first subject over a historic period of time.

The method may further comprise obtaining a floor plan including an indication of boundaries of a facility in which the first subject is located. Determining the level of interaction may be further based on the indication of boundaries in the floor plan.

In some embodiments, determining a level of interaction may comprise determining a duration for which: i) the first subject and the second subject are within a threshold proximity of one another; and ii) the direction in which the first subject is facing is within a defined angular range of the direction in which the second subject is facing.

In some embodiments, the first relative orientation data may comprise a model describing a relationship between the orientation of the first device and the facing direction of the first subject.

In some embodiments, the first location data and the second location data may be determined using at least one of a Bluetooth-based localisation system and a WiFi-based localisation system.

According to a second aspect, the present invention provides a computer program product comprising a non-transitory computer readable medium, the computer readable medium having computer readable code embodied therein, the computer readable code being configured such that, on execution by a suitable computer or processor, the computer or processor is caused to perform steps of any of the methods disclosed herein.

According to a third aspect, the invention provides an apparatus for determining a level of interaction experienced by a subject. The apparatus comprises a processor configured to receive first location data indicative of a location of a first device relative to at least one reference location, the first device being associated with the body of a first subject; obtain first relative orientation data indicative of an orientation of the first device relative to a facing direction of the first subject; receive first orientation data indicative of an orientation of the first device relative to a first reference frame; receive second location data indicative of a location of a second device relative to at least one reference location; receive second orientation data indicative of an orientation of the second device relative to a second reference frame; determine, based on the obtained first relative orientation data and the first orientation data, an indication of an absolute orientation of the first subject with respect to the first reference frame; and determine, based on the first location data, the second location data, the second orientation data and the indication of the absolute orientation of the first subject, a level of interaction between the first subject and the second device.

According to a fourth aspect, the invention provides a system comprising a first device configured to be worn on the body of a first subject, a second device, and processing apparatus configured to receive first location data indicative of a location of the first device relative to at least one reference location; obtain first relative orientation data indicative of an orientation of the first device relative to a facing direction of the first subject; receive first orientation data indicative of an orientation of the first device relative to a first reference frame; receive second location data indicative of a location of the second device relative to at least one reference location; receive second orientation data indicative of an orientation of the second device relative to a second reference frame; determine, based on the obtained first relative orientation data and the first orientation data, an indication of an absolute orientation of the first subject with respect to the first reference frame; and determine, based on the first location data, the second location data, the second orientation data and the indication of the absolute orientation of the first subject, a level of interaction between the first subject and the second device.

In some embodiments, the system may further comprise a sensor to capture at least one of image data and audio data in respect of the at least one of the first subject and the second device, wherein the processing apparatus may be configured to determine the level of interaction further based on at least one of the image data and the audio data.

In some embodiments, the first device may comprise a first magnetometer, the second device may comprise a second magnetometer, and the first orientation data and the second orientation data may be acquired using the first magnetometer and the second magnetometer respectively.

In some embodiments, the second device may be configured to be worn on the body of a second subject. The processing apparatus may be configured, in some embodiments, to obtain second relative orientation data indicative of an orientation of the second device relative to a facing direction of the second subject; determine, based on the obtained second relative orientation data and the second orientation data, an indication of an absolute orientation of the second subject with respect to the second reference frame; and determine, based on the first location data, the second location data, the indication of the absolute orientation of the first subject and the indication of the absolute orientation of the second subject, a level of interaction between the first subject and the second subject.

These and other aspects will be apparent from and elucidated with reference to the embodiment(s) described hereinafter.

BRIEF DESCRIPTION OF THE DRAWINGS

Exemplary embodiments will now be described, by way of example only, with reference to the following drawings, in which:

Fig. 1 is a schematic illustration of an example of a system for determining a level of interaction experienced by a subject;
Fig. 2 is a schematic illustration of two subjects, showing how a wearing model may be used to describe how a device is being worn by a subject;
Fig. 3 is flowchart of an example of a method for determining a level of interaction experienced by a subject;
Fig. 4 is flowchart of a further example of a method for determining a level of interaction experienced by a subject;
Fig. 5 is a schematic illustration of a processor in communication with a non-transitory computer readable medium;
Fig. 6 is a schematic illustration of an example of an apparatus for determining a level of interaction experienced by a subject; and
Fig. 7 is a schematic illustration of an example of a system for determining a level of interaction experienced by a subject.

DETAILED DESCRIPTION OF EMBODIMENTS

Determining a level of interaction experienced by a subject, such as an interaction between a subject and a device or between a pair of subjects, can be important in a range of contexts. One such example is in a care home setting where residents may spend large proportions of their day in a confined space and often in the vicinity of other residents. It may be important to assess social interactions between a resident and a care provider in order to determine, for example, a level of care or attention that the resident is experiencing and/or to assess a level of social interaction of the resident with other residents, which may be used to determine a level of social isolation of the resident. One way in which this information may be used is to tailor an individual's social activities in order to combat loneliness, for example.

Determining a level of interaction between a subject and a device, or between a pair of subjects, typically involves a measurement of a location of the subject and a measurement of a location of a device of interest, and/or of a second subject, respectively. A location of a subject may be determined by determining a location of a device associated with the subject, which may include, for example, a smart watch, a mobile telephone, a smart phone, an identification badge, or a sensor located on or within a wearable device such as a pair of glasses, a hearing aid, or the like worn by the subject, or otherwise positioned about the body of the subject. Data relating to a location of a device may be transmitted from the device and received by one or more receivers located in, on or around a facility. Thus, the determined location may be a location relative to one or more of the receivers. Using the received location data, a location of the device may be determined using one or more methods including, for example, trilateration, angle of arrival, or the like, as described in more detail below. Orientation data relating to an orientation of a device associated with a subject may alternatively, or additionally, be transmitted from the device to the one or more receivers, which may be used to improve the accuracy of an assessment of a level of interaction between two devices and/or subjects. To further improve the accuracy of the determination of the level of interaction between a subject and a device, or between two subjects, a model may be used to quantify how a device is orientated in relation to a facing direction of a subject. The model may be referred to as a "wearing model". As used herein, the term "facing direction" is intended to refer to a direction in which the subject is facing, for example, a direction normal to the coronal or frontal plane of the subject's head.

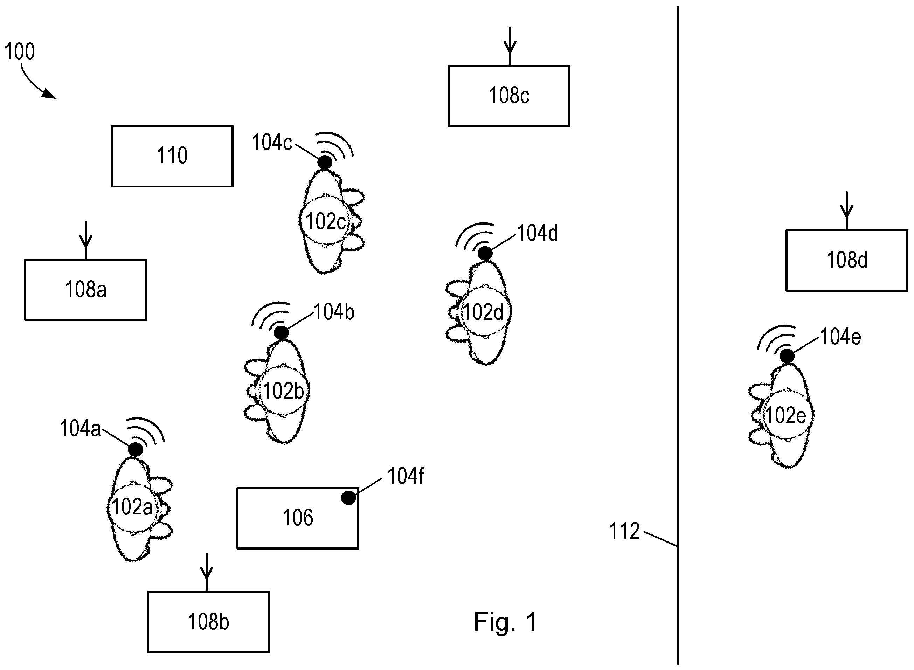

Fig. 1 shows a system 100, such as a localisation system, for determining a level of interaction experienced by one or more of a plurality of subjects 102a, 102b, 102c, 102d, 102e. The system 100 may, for example, comprise a system present (e.g. installed) within a care setting, such as a care facility. The system 100 may comprise one or more devices 104a, 104b, 104c, 104d, 104e, 104f (generally 104). A first device 104a may be positioned about the body of a first subject 102a. In some embodiments, the first device 104a may comprise a wearable sensor such as a smart watch positioned on a wrist of the first subject 102a and, in other embodiments, the first device may comprise a device that forms a part of (e.g. located on or within) a wearable sensor. In some embodiments, the second device (e.g. 104b) may be positioned about the body of a second subject 102b. In other embodiments, the second device (e.g. 104f) may be located on or within a host device 106 located at or within a facility (e.g. a building), where the host device may comprise, for example, a computer, a machine such as a vending machine located in a care home facility, a ticket-issuing machine at a train station, or the like. The three arcs located next to each device 104a to 104e represent a signal being emitted from each device (e.g. a radiofrequency electromagnetic wave). The signal may be emitted from each device 104 in all directions. In some examples, none of the devices 104 may be emitting a signal at a given time. In other examples, one or more of the devices 104 may be emitting a signal at a given time. Throughout this specification, the first subject 102a and the second subject 102b, and the first device 104a and the second device 104a, 104f, will be referred to specifically, in order to aid understanding and to improve clarity, although it is envisioned that the various embodiments disclosed herein may apply to any number of subjects (e.g. one or more of the subjects 102a to 102e), and any number of devices (e.g. one or more of the devices 104a to 104e), compatible with and/or accessible to the system 100. For example, the first subject 102a may interact with the second device 104b, 104f and, equally, the second subject 102b may interact with the second device 104b, 104f. As another example, a third subject 102c may interact with the first device 104a, the second device 104b, 104f or a third device 104c.

The first device 104a of the system 100 may comprise, or be associated with (e.g. located on or within), a wearable sensor such as a smart watch, a smart phone, a mobile telecommunications device, a personal emergency call device, a pager (e.g. a medical professional's pager), an assistive device (e.g. a walking aid), a necklace, a pendant, a pair of smart glasses, a shoe sensor, a pedometer, a sensor worn on a belt, a sensor worn on the lower back of a subject 102a, 102b, a medical device, or the like, and may be equipped with one or more wireless transmitters and/or a dedicated communication protocol (e.g. Bluetooth (RTM), Wi-Fi, or the like). A range of transmit and receive configurations may be used to facilitate determination of a location and/or an orientation of one or more of the first and second devices 104a, 104b and thus the relative locations (e.g. a proximity) of the first subject 102a and the second device 104b and/or the relative locations of the first subject 102a and the second subject 102b. Location data comprising location information of the first device 104a (and therefore the first subject 102a) and the second device 104b, 104f (and therefore the second subject 102b if the second device 104b is worn by the second subject) may be used to determine, for example, the distance between the first subject 102a and the second device 104b, or the distance between the first subject 102a and the second subject 102b, respectively. Similarly, orientation data comprising orientation information of the first device 104a and the second device 104b, or the orientation of the first subject 102a and the second subject 102b may be obtained (as discussed in more detail below). In some embodiments, one or more of the devices 104 may comprise a Bluetooth (RTM) tag, which is a low-power, battery-operated Bluetooth (RTM) transmitter. The tag may be programmed to transmit a signal on a periodic basis, which may be received by Bluetooth (RTM) locators/receivers and/or one or more other Bluetooth (RTM) tags (e.g. inter-tag communication). In some examples, one or more of the devices 104 may comprise a receiver configured to receive data from one or more other devices; for example, the first device 104a may include a receiver configured to receive data from the second device 104b. In other embodiments, a separate receiver 108a may receive data from the devices. The various embodiments described herein may be used to receive, obtain and/or determine location and orientation data, as well as sensor data from other sensors including a camera and/or a microphone, in real time. Alternatively, data may be collected and stored for later analysis.

In some embodiments, the first subject 102a may interact with the second device 104b, which may be located on or within a vending machine, a ticket-issuing machine, or the like. In other embodiments, the first subject 102a may interact with the second subject 102b.

The localisation system 100 may comprise one or more receivers 108. The example shown in Figure 1 includes four receivers 108a, 108b, 108c, 108d. In other examples, more or fewer receivers may be used. In some examples, one or more of the receivers 108a to 108d may be located in the vicinity of one or more of the devices 104 and/or may be located at fixed locations within, on or around a building, area or facility in which one or more of the subjects 102 are located. An indoor localisation system is a localisation system 100 that is located indoors, such as within a care facility. In some examples, one or more of the receivers 108 may be located on a wall, floor, ceiling, door, in a central server room, or some other location within, or outside, of the facility. In some examples, one or more of the receivers 108 may be located on a stand located within the facility. In some embodiments, the receivers 108 may be configured to receive data via Bluetooth (RTM) and/or Wi-Fi (e.g. IEEE_802.11), or any other communications channel. One or more of the receivers 108 may be configured to receive data from a device 104, such as the first device 104a and/or the second device 104b including, for example, data relating to one or more of a location of the first device and/or the second device, an orientation of the first device and/or the second device, or the like. In some embodiments, one or more of the receivers 108 may be located outside of the facility and comprise, for example, a radio mast or a radio tower. In yet further embodiments, one or more of the receivers 108 may be located on a satellite platform. In some embodiments, one or more of the receivers 108 may be associated with (e.g. located on or within) one or more of the devices 104, such as the first and second devices 104a, 104b. The receivers 108 may be connected to, or be capable of transmitting data to, a location engine, server or processing apparatus 110 (e.g. a localisation server) that may collate, process and/or forward to an onward location any received data. In some examples, any of the devices 104 and/or the receivers 108 may be configured to transmit data to the processing apparatus 110 wirelessly. In some examples, one or more of the receivers 108 may comprise a memory for storing the received data (e.g. location data and/or orientation data), and/or a processing apparatus 110 to process the received data and/or to transmit the received data to a server or other processing apparatus, such as the localisation server. In some embodiments, one or more of the receivers 108 of the system 100 may be configured to receive location data and/or orientation data from one or more of any other receivers 108 and/or devices 104 in the system 100. Alternatively, or in addition, any device 104 of the system 100 may be configured to receive location data and/or orientation data from any other device and/or receiver 108 in the system. In some embodiments, a processing apparatus 110 may be associated with (e.g. located on or in) a device 104, such as the first device 104a, the second device 104b or one or more of the receivers 108 of the system 100.

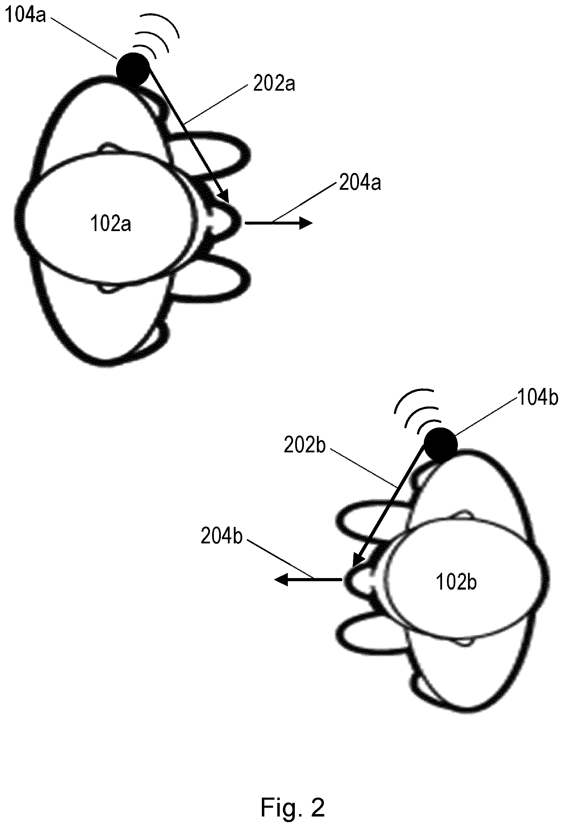

The processing apparatus 110, such as localisation server, of the system 100 may be configured to collect, synchronize and/or manage data received from one or more sensor sources, such as one or more of the receivers 108 or devices 104. The processing apparatus 110 may be associated with (e.g. be in communication with) a memory that stores (e.g. in a database) a wearing model corresponding to one or more of the devices 104 in the system 100. With reference to Fig. 2, the wearing model describes how a device 104 is being worn by a subject using a relationship between the orientation of the device and a facing direction of the respective body of a subject, as indicated by arrows 202a, 202b. Arrows 204a, 204b represent a 'facing direction' of each subject (i.e. a direction in which the subjects 102a and 102b are facing), as discussed in more detail below. Each device may be worn in an absolute orientation, and it may be assumed that the device remains generally in that orientation. For example, if the device 104 is incorporated into a badge worn on the chest of the subject, then the orientation of the device may be considered to be generally the same as the facing direction of the subject. If the device 104 is incorporated into a hearing aid worn by the subject, then the orientation of the device may be considered to be generally perpendicular to the facing direction of the subject. In this example, the wearing model may describe the relationship between the orientation of the device 104 (i.e. the hearing aid) and the facing direction of the subject as a 90-degree rotation. The wearing model may include functions to take into account a situation where a subject turns their head, or where the absolute orientation of the device 104 is not constant (e.g. varies over time).

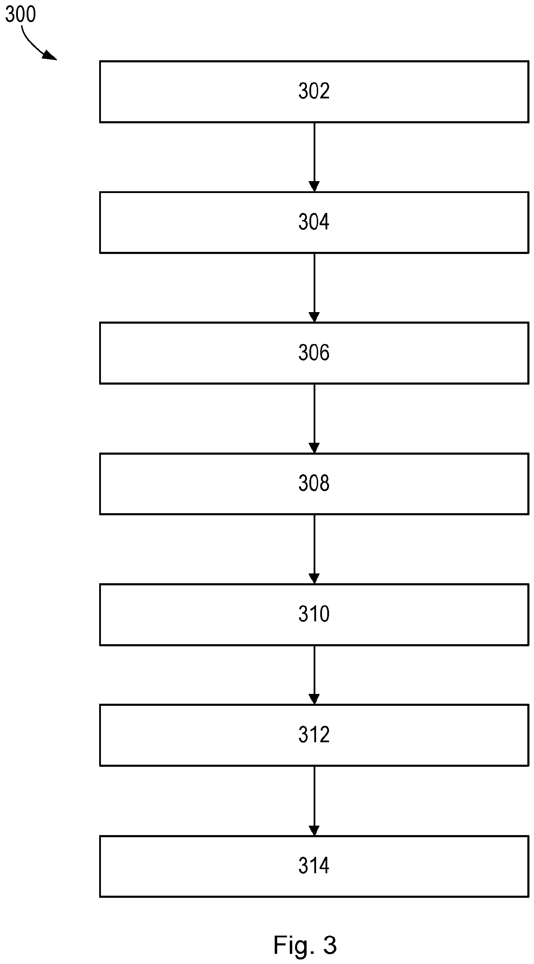

The processing apparatus 110 may comprise a data processor that is configured to: receive (302; Fig. 3) first location data indicative of a location of the first device 104a relative to at least one reference location, the first device being positioned about the body of the first subject 102a. The first location data may, for example, comprise data describing the location of the first device 104a relative to one or more receivers 108. The data processor may be further configured to obtain (304; Fig. 3) first relative orientation data indicative of an orientation of the first device 104a relative to a facing direction of the first subject 102a. The first relative orientation data may comprise the wearing model - a model defining the relationship between orientation of the first device 104a and the facing direction of the subject 102a wearing the first device. The data processor may be further configured to receive (306; Fig. 3) first orientation data indicative of an orientation of the first device 104a relative to a first reference frame. The first orientation data may comprise data acquired by or received from a sensor capable of measuring an orientation (e.g. relative to the Earth). Thus, in some examples, the reference frame may comprise the Earth's reference frame, or the world coordinate system (WCS). The data processor may be further configured to receive (308; Fig. 3) second location data indicative of a location of a second device 104b relative to at least one reference location. In some examples, the same reference location may be used for determining the locations of the first and second devices 104a, 104b. The data processor may be further configured to receive (310; Fig 3) second orientation data indicative of an orientation of the second device 104b relative to a second reference frame. In some examples, the same reference frame may be used for determining the orientations of the first and second devices 104a, 104b. Thus, the first reference frame and the second reference frame may be the same. The orientation of the second device 104b may be determined in a manner similar to that used for the first device 104a. The data processor may be further configured to determine (312; Fig. 3), based on the obtained relative orientation data and the first orientation data, an indication of an absolute orientation of the first subject 102a with respect to the first reference frame; and/or determine (314; Fig. 3), based on the first location data, the second location data, the second orientation data and the indication of the absolute orientation of the first subject 102a, a level of interaction between the first subject 102a and the second device 104b. The data processor of the processing apparatus 110 may be further configured to compute a location of one or more of the devices 104 using trilateration and/or angle of arrival, and/or may conduct further application-specific reasoning such as determining a social activity score (e.g. based on a number, a type and/or a length of one or more interactions of a subject).

In some examples, the system 100 may comprise an output device such as a smart phone, a tablet, a computer, or the like, that may visualize data (e.g. application-specific data) and/or any of the above-mentioned data such as a location, an orientation, a direction in which the first subject 102a is facing and/or a level of interaction between the first subject 102a and the second device 104b.

According to a first aspect, the present invention provides a method for determining a level of interaction experienced by a subject 102. Fig. 3 is a flowchart of an example of such a method 300. The method comprises, at step 302, receiving first location data indicative of a location of a first device 104a relative to at least one reference location. In some examples, trilateration may be used to determine the location of the first device 104a (i.e. the first location data) and/or of a subject (e.g. the subject 102a) by determining the distance of the device from at least three known reference points, such as by using data from three or more receivers 108. In the case of Bluetooth (RTM), a locator may estimate the distance between the locator and a Bluetooth (RTM) tag based on a received signal intensity (RSSI) from the tag, or, equivalently, a received signal strength from the tag. A Bluetooth (RTM) locator may be considered to be one example of a receiver 108. Each locator in a plurality of locators may be configured to determine the RSSI, which, using trilateration, may be used to determine the location of a tag. In other examples, data received by, or generated by, the receivers 108 (e.g. RSSI) may be sent to a remote server for processing, such as a server located in the cloud, which may be configured to determine the RSSI and/or perform the process of trilateration using data from three or more receivers 108 to determine the location of the device 104. In other embodiments, a device 104 of the system 100 may be configured to perform the process of trilateration.

A direction from which a signal is received by a receiver 108 as emitted from a device 104, or, equivalently, a direction of propagation of a signal beginning at the device and incident on the receiver, may be determined using a method such as angle of arrival (AoA) determination or angle of departure (AoD) determination, as described herein. The AoA method may be used to increase the accuracy of an estimate of a location, or localisation, of a device 104, such as a Bluetooth (RTM) tag. The angle of arrival method may be used alone or in combination with trilateration, or with any other location-determining technique. One or more of the receivers 108 of the system 100 may comprise a plurality of antennas arranged in an array (e.g. a multiple antenna) allowing determination of a phase of a received signal at each antenna in the array, and therefore a phase difference between one or more pairs of antennas in the array, as the received signal passes over the antenna array. The phase change of the received signal across the antenna array may be due to the difference in the distance between each antenna in the array and a transmitting antenna (e.g. an antenna located in a device 104 configured to transmit a signal, such as a Bluetooth (RTM) tag). In some examples, the transmitting antenna may comprise a single antenna. A receiver 108a to 108d of the one or more receivers may therefore be configured to determine a relative signal direction emitted from a device 104a, 104b based on the phase difference of a received signal as it passes over an antenna array of the receiver. In some embodiments, the transmitting antenna, which may be a single antenna, may transmit a direction-finding signal specifically for the purpose of enabling the determination the location of the transmitting antenna.

The determination of a location of a device 104 and/or a subject 102 may be further enhanced by combining the location estimate using trilateration (e.g. using RSSI data) and/or AoA with a facility floor plan, where the facility floor plan may highlight any boundaries 112 (e.g. walls, doors, or the like) within the facility. The first and/or second subject 102a, 102b (e.g. care home residents) may be located in the same room within a facility or may be located in different rooms. Separation 112 may comprise a wall, door, or some other boundary, that separates a subject (e.g. the first subject 102a) from one or more other subjects. For example, a care home resident may be located in their bedroom, which is separated from a communal area by one or more walls. By combining a floor plan of the facility with location data determined via trilateration and/or AoA, the location of a device 104 and/or the location of a subject 102 may be determined as well as the location within the facility. This information may be of use when, for example, assessing interactions between a pair of subjects (e.g. the first and second subjects 102a, 102b); if the subjects are determined to be in close proximity but separated by a boundary 112, such as a wall, the subjects are unlikely to be interacting, whereas, in contrast, if the subjects are determined in close proximity and are not separated by a boundary, there may be a higher likelihood that they are interacting. A proximity of two devices 104, such as the first device 104a and the second device 104b, and/or a proximity of two subjects 102, such as the first subject 102a and the second subject 102b, may be determined using a location of the first device and a location of the second device. For example, the proximity of two devices 104 (e.g. the first device and the second device) may be determined by calculating the Euclidean distance between the devices. In some embodiments, the first device 104a may be positioned about the body of the first subject 102a. In other words, the first device 104a may be positioned on a body part or on an item of clothing or wearable device of the first subject 102a. In some embodiments, the second device 104b may be positioned about the body of the second subject 102b. In other embodiments, the second device 104b may be positioned on the floor, wall or ceiling of a facility, positioned on a stand located within the facility, or the like, and may comprise a ticket issuing device, a vending machine, or the like. The second device 104 may comprise a stationary device in that it is intended to stay in the position and/or location that it is installed, although the location of the device may be moveable.

A location of a device (e.g. a tag) may therefore be represented as:

$$t_1 \rightarrow \left( p_{t_1,1}, p_{t_2,2}, p_{t_3,3}, \dots, v_{t_1,1}, v_{t_2,2}, v_{t_3,3}, \dots \right) \rightarrow a_{t_1}$$

where $t_1$ represents a first tag (e.g. a first Bluetooth (RTM) device or the like), $p_{t_1,1}$ represents a proximity of the first tag to a first locator (e.g. a receiver 108), $v_{t_1,1}$ represents a direction vector from the first tag to the first locator (which may be used, for example, for the angle of arrival method), and $a_{t_1}$ represents a location of the first tag (e.g. in the world coordinate system). As will become apparent later in the description, $a_{t_1}$ may also contain orientation information.

Location data (e.g. data relating to a location of a device 104 or to a location of a subject 102) may be determined relative to a reference location. Location data may be determined with reference to the Earth (i.e. where the Earth is the reference location), for example, using the world coordinate system (WCS), or any other geographic coordinate system. In some examples, location data may be determined with reference to a defined location, such as a location of a central server room, a location of a fixed receiver 108 (e.g. if the receiver is located, or installed, in a predefined location), such that the defined location may be fixed (i.e. not change over time). In other examples, location data may be determined with reference to a defined location that does move (i.e. is not in a fixed location), whereby the location of the moveable defined location used as a reference is determined in a geographic coordinate system or with reference to a second reference location allowing the location data to be determined relative to the second reference location. For example, the first device 104a may serve as a receiver 108 for the second device 104b in the system 100, whereby both the first device and the second device may both be moving relative to one another. In this example, the location of the second device 104b may be determined with reference to the location of the first device 104a and, in turn, the location of the first device may be determined with reference to a reference location such as those described above (e.g. a geographic coordinate system or a location of a fixed receiver such as a radio mast).

A device 104 may transmit data relating to a location and/or orientation of the device on a periodic basis, for example, transmitting location data ten times per second, once per second, once per five seconds, once per ten seconds, once per minute, or the like. The receivers 108 may transmit the data relating to a location and/or orientation of the device 104 to a server at the same frequency at which the data is received by the receivers. In some examples, the receivers 108 may store, or aggregate, the received data for a defined amount of time (e.g. 1 second, 5 seconds, 10 seconds, 1 minute, 10 minutes, or the like) before transmitting the data to the server.

The method 300 comprises, at step 304, obtaining first relative orientation data indicative of an orientation of a device 104 (e.g. the first device 104a) relative to a facing direction of a subject (e.g. the first subject 102a). Use of the first relative orientation data may contribute to a determination of an absolute orientation of the subject 102a. The orientation of the subject is generally considered to be determined based on the orientation of the subject's head (e.g. the facing direction of the subject). In some examples, however, data from additional data sources (e.g. cameras) may be used to determine more precisely the orientation of the subject's head and body. The absolute orientation of the subject 102a may be determined with respect to a first reference frame (e.g. with respect to a reference frame of the first device, such as a magnetometer measurement with reference to the Earth's magnetic field). The first relative orientation data may be obtained from a device 104, a receiver 108, a processing apparatus 110, a server (e.g. a local server within the facility or a remote server in the cloud), or the like. The first relative orientation data may comprise a model (e.g. a wearing model) describing a relationship between the orientation of a first device 104a and a facing direction of the first subject 102a. In other words, the model may describe the orientation of the first device 104a relative to a facing direction of the first subject 102a. The model may be based on anthropometric constraints; for example, the model may prescribe that a smart watch is positioned on a subject's left wrist, that a name badge is worn on the torso of the subject, that a hearing aid is positioned in the right ear of the subject, or the like, relative to a facing direction of the subject (e.g. in a direction normal to the subject's coronal plane).

A wearing model may comprise a rotation matrix when, for example, a device 104 is worn in a fixed position (e.g. a fixed facial position), such as a hearing aid. Biometrical features such as body height or any other pre-defined bodily dimensions, whether based on an average human body or based on dimensions of a specific subject 102, may be used within the wearing model in order to allow the relative orientation of a device 104 to the facing direction of a subject to be represented accurately. In some examples, an absolute orientation of the subject 102 with respect to a reference frame (i.e. the facing direction of a subject with respect to a reference frame) may be determined based on the relative orientation data indicative of an orientation of a device relative to a facing direction of the subject and the orientation data corresponding to the device 104. For example, if the subject 102 is wearing a hearing aid in their right ear (as quantified using the wearing model - i.e. relative orientation data indicative of an orientation of a device relative to a facing direction of the subject) and the orientation of the hearing aid is known (e.g. using a magnetometer), then the orientation of the subject's nose (or, equivalently, the facing direction of the subject - i.e. an absolute orientation of the subject with respect to the hearing aid's reference frame) may be determined based on the human anatomy, such as average dimensions of a human head or, alternatively, based on the particular dimensions of the head of the subject. Another example is that of a smart watch positioned on the left wrist of a subject 102 such that, when the subject is in a standing position and their arms are by their sides, an orientation of the subject's nose (or, equivalently, any other body part of the subject) and thus an absolute orientation of the subject with respect to a reference frame (i.e. a facing direction of the subject) may be determined, based on a relative orientation of the smart watch (as quantified using the wearing model) and an orientation of the smart watch.

Depending on the device 104 and/or the position of the device in relation to the subject 102, there may be relatively lower or higher uncertainty with regard to the determination of the facing direction (e.g. the absolute orientation of the subject with respect to a reference frame) of the subject when using the relative orientation data (i.e. a wearing model) corresponding to the device. The uncertainty with regard to the determination of the absolute orientation of the subject 102 with respect to a reference frame may translate into an uncertainty in a determination of a level of interaction of the subject and a device and/or second subject. For example, if a subject 102 is wearing a hearing aid, an uncertainty associated with an orientation of the subject's nose, and equivalently an uncertainty associated with a direction in which the subject is facing, may be low. In the case of a smart watch, while the uncertainty associated with the determination of an absolute orientation of a subject 102 (e.g. their facing direction) with respect to a reference frame based on the relative orientation of the device 104 when the subject is stood up and their arms are dangling by their sides may be relatively small, the uncertainty may increase as the subject changes position; for example, if the subject changes from a standing position to a sitting or lying position, or if the subject moves their arms during a conversation, then determining a facing direction of the subject based on the location of the device and the relative orientation data may be associated with a relatively lower accuracy compared to when the subject is standing with their arms by their sides. A tolerance may be built into the wearing model to account for movements; for example, a tolerance for neck rotations may be introduced for trunk worn devices (e.g. a pendant). To improve the accuracy of a determination of an absolute orientation of a subject 102 with respect to a reference frame based on the relative orientation data, the relative orientation data may comprise data acquired in respect of an orientation of a device 104 relative to the facing direction of the subject over a historic period of time. Thus, in some embodiments, the wearing model may comprise probabilistic estimates based on historical data. In cases where the wearing model may be more uncertain (e.g. a smart watch worn on a subject's 102 wrist), an angle of the subject's wrist may still be constrained during free living activities and therefore the historical data may be able to provide useful information. The location data of the device 104 and/or the relative orientation data corresponding to the device 104, which may be transmitted on a periodic basis (e.g. once per second or any other frequency), may be averaged over a period of time and may lead to an improved accuracy of a determination of a facing direction of a subject 102; for example, the location and/or relative orientation data of the device 104 may be averaged over a time period of 1 second, 10 seconds, 1 minute, 5 minutes, or the like. In some embodiments, two or more devices 104 associated with a subject 102 (e.g. positioned about the body of the subject) may be used alone or in combination to determine a location, an orientation, and/or a facing direction of the subject.

At step 306, the method 300 comprises receiving first orientation data indicative of an orientation of a device 104 (e.g. a first device) relative to a reference frame (e.g. a first reference frame). A reference frame may be any suitable reference frame that allows for an assessment of the orientation of the device in question. For example, an orientation of a device 104 may be determined using one or more of a magnetometer, gyroscope and accelerometer. A device 104 may comprise an inertial measurement unit. If the orientation of a device 104 is determined using a magnetometer, then the reference frame may be the Earth's magnetic field (e.g. with respect to magnetic north and/or magnetic south poles, or vector orientation of the Earth's magnetic field). Similarly, a gyroscope associated with a device 104 may be able to determine a rate of rotation around a particular axis and may, therefore, be capable of detecting a change in the orientation of the device. In this case, a reference orientation of a device 104 comprising a gyroscope may be determined such that any subsequent measurement of orientation may be determined relative to this reference orientation. The reference orientation may be the orientation of the gyroscope when it was installed in the associated device 104, or any other suitable reference orientation. An accelerometer may be able to determine an orientation of a device 104 using gravity and, therefore, relative to the Earth and/or the Earth's gravitational pull.

An indication of a direction in which a subject 102 is facing may be determined based on obtained relative orientation data and orientation data of a device 104. The indication of an absolute orientation of a subject 102 may hold information about a pose of a subject such as whether the subject is standing or lying, and/or may hold information about a space in which the subject is able to interact with a device 104 and/or another subject. An absolute orientation of a subject 102 with respect to a reference frame, or a facing direction of a subject, may be with reference to Earth's magnetic field (e.g. north, south, east, west) and/or may be quoted as a number of degrees (e.g. 10 degrees from north, north by east, or the like), may be with reference to a facility in which the subject is located (e.g. with reference to a floor plan of the facility), may be with reference to a second device 104b and/or a second subject 102b, or the like. In some examples, the absolute orientation of the subject 102 with respect to a reference frame (i.e. the direction in which the subject 102 is facing) may be a specific point (e.g. 10 degrees north) or, in other examples, may be an angular range (e.g. between 5 and 15 degrees north). In yet further examples, the absolute orientation of the subject 102 with respect to a reference frame may be attributed to a quadrant (e.g. 0 to 89 degrees, 90 to 179 degrees, 180, 269 degrees and 270 to 359 degrees), or any other fraction (e.g. eighths, sixteenths, or the like) of a 360 degrees compass-like two-dimensional representation of orientation or facing direction. In other examples, the orientation of a housing plan (e.g. a floor plan of an area, a building or a facility) may be determined relative to the Earth's magnetic field.

A level of interaction between a subject 102 and a device 104 may be determined based on location data of a first device 104a positioned about the body of a subject 102a, location data of a second device 104b, orientation data of the second device and an indication of the absolute orientation of the subject.

In some embodiments, a test function may be applied to check whether reference points of a first device 104a and a second device 104b face each other. The test function may use a vector configuration and may take into account location estimates of the first device 104a and the second device 104b (e.g. defined using the world coordinate system), a wearing model of the first device and/or second device (e.g. given with respect to the body coordinate system), and a reference point direction or facing direction (e.g. given with respect to the body coordinate system). To ensure that the direction of the first device 104a and the direction of the second device 104b are opposing (e.g. anti-parallel) to each other, an inner product may be calculated according to the following equation:

$$\theta = \arccos\left(\frac{v \cdot w}{\|v\| \cdot \|w\|}\right)$$

or according to equation:

$$v \cdot w = -\|v\| \cdot \|w\|$$

where

$$v = a_{t_1} + m_{wearing,t_1}$$

$$w = a_{t_2} + m_{wearing,t_2}$$

where $t_1$ and $t_2$ represent the first device and the second device, respectively, $a_{t_1}$ and $a_{t_2}$ represent the location information (i.e. position and orientation) of the first device and the second device, respectively, $m_{wearing,t_1}$ and $m_{wearing,t_2}$ represent the wearing model of the first device and second device, respectively, and $v$ and $w$ represent the facing direction of the first subject and the second subject, respectively. In some examples, a magnetometer may be used to determine the facing direction of the first device 104a and/or second device 104b. To extend the notion of facing from strict anti-parallelism towards a wider angular range, margins may be used to enclose (e.g. define) an acceptable angle of the direction vectors $v$ and $w$ such that

$$\theta \in [180° - \delta, 180° + \delta]$$

where $\delta$ represents the acceptable margin from exact facing in any direction, which is half of the acceptable wider angular range. For example, if a first subject is within $\pm 10$ degrees of a direct line-of-sight of the second subject, and the second subject is within $\pm 10$ degrees of a direct line-of-sight of the first subject, then the two subjects may be determined to be facing one another.

At step 308, the method 300 comprises receiving second location data indicative of a location of a second device 104b relative to at least one reference location. The location of a second device 104b may be determined in the same way (i.e. using the same method or methods) as for the first device 104a, including, for example, trilateration and/or angle of arrival. The location of the second device 104b may be fixed (i.e. stationary at a particular location), for example, a vending machine located in a care home facility, a ticket-issuing machine at a train station, or the like.

Step 310 of the method 300 comprises receiving second orientation data indicative of an orientation of the second device 104b relative to a second reference frame. The orientation of a second device 104b may be determined in the same way as for the first device 104a by using, for example, a gyroscope, magnetometer and/or accelerometer. An inertial measurement unit may be used to determine an orientation of the second device 104b. In examples where the second device 104b is in, on, or otherwise associated with a host device 106 (e.g. a machine), then the orientation of the host device (and therefore the second device) may be known. For example, the host device 106 and/or the second device may be positioned or installed in a particular orientation, and the orientation may be stored in a memory accessible by the processing device performing the method.

Step 312 of the method 300 comprises determining, based on the obtained relative orientation data and the first orientation data, an indication of an absolute orientation of the first subject 102a with respect to a first reference frame. As mentioned previously, the step of determining an indication of an absolute orientation of the first subject 102a with respect to the first reference frame may be performed using a processing apparatus 110, which may be located in one or more of a receiver 108, a device 104 (e.g. the first device 104a, the second device 104b, or another device), a server located within a facility, a server located within the cloud, or the like.

Step 314 of method 300 comprises determining, based on the first location data, the second location data, the second orientation data and the indication of the absolute orientation of the first subject 102a, a level of interaction between the first subject and the second device 104b. Any suitable algorithm may be used for processing the first location data, the second location data, the second orientation data and the indication of the absolute orientation of the first subject 102a to obtain a determination of a level of interaction between the first subject and the second device 104b. The level of interaction between the first subject 102a and the second device 104b may be based on a proximity between the first subject and the second device, the orientation of the first subject and/or of the second device, and the indication of the absolute orientation of the first subject with respect to the first reference frame. In some examples, an amount of time that the first subject 102a and the second device 104b and/or the second subject 102b are facing each other may be determined. For example, a relatively low level of interaction may be attributed to a situation where the first subject 102a and the second device 104b may be in close proximity but the facing direction of the first subject (determined by using, for example, the orientation of the first device with respect to a first reference frame) is away from the second device. In some examples, the level of interaction depends on the proximity of the first subject 102a and the second device 104b in addition to the number of other devices within an area. For example, a relatively higher level of interaction may be attributed to a situation where there is only a first device 104a (associated with a first subject 102a) and a second device 104b within an area (e.g. a room within a care facility), compared to a situation where many additional devices are present in the room, as well as the location and/or orientation of these devices relative to the first device and the second device. In another example, a relatively higher level of interaction may be attributed to a situation where the first subject 102a and the second device 104b are in less close proximity but the facing direction of the first subject is towards the second device (e.g. the second device is within sight of the first subject). In other examples, a relatively lower level of interaction may be attributed to a situation where the orientation of the first subject 102a is above a predefined threshold (e.g. 30 degrees above the horizontal); in this case, the first subject may be in reclining chair and may therefore be less likely to be interacting with the second device 104b. In some examples, the level of interaction depends on the time that the first subject 102a and the second device 104b and/or second subject 102b are facing each other. For example, a higher level of interaction may be associated with an interaction where the first subject 102a and second device 104b are facing each other for a relatively long time. In some examples, a difference in an angle of orientation of the first device 104a and the second device 104b may be used to refine the determination of the level of interaction; for example, a relatively higher level of interaction may be associated with a situation where an orientation of the first device 104a is at 30 degrees above the horizontal and an orientation of the second device is 30 degrees below the horizontal. In this case, the first subject 102a may be sitting down and looking upwards towards the second subject 102b and the second subject may be standing up and looking downwards towards the first subject.

In some embodiments, statistics relating to the determination of a level of interaction between a first subject 102a and a second device 104b and/or a second subject 102b may be collected or and/or aggregated in an automated way. To determine a level of interaction of the first subject 102a and the second device 104b (and/or the second subject 102b), data may need to be aggregated over a period of time. In some examples, temporal constraints may be used to filter short social interactions (e.g. of several seconds) or social interactions that have been interrupted within a short period of time. This information may be used, for example, for improved staff planning, task planning and care reporting in the case of a care home, as highlighted previously. In some embodiments, subjects may be paired and/or grouped, which may take into account, for example, whether subjects 102 are located in the same room (e.g. using a facility plan or floor plan). By grouping subjects prior to running a full algorithm for each pair of subjects (e.g. the first and second subjects 102a, 102b) (e.g. for determining a level of interaction for each pair of subjects) may reduce computing power requirements; for example, if two subjects are determined to be in different rooms, it may be that there is a relatively low chance that the two subjects are be interacting.

In some embodiments, a subgroup may be defined and social interactions assessed amongst the subgroup. For example, a group of care providers (i.e. two or more) may provide care to a single resident, in which case a level of interaction between each of the group of care providers and the resident may be determined in order to assess an aggregate, combined, or total, amount of care that the resident has received.

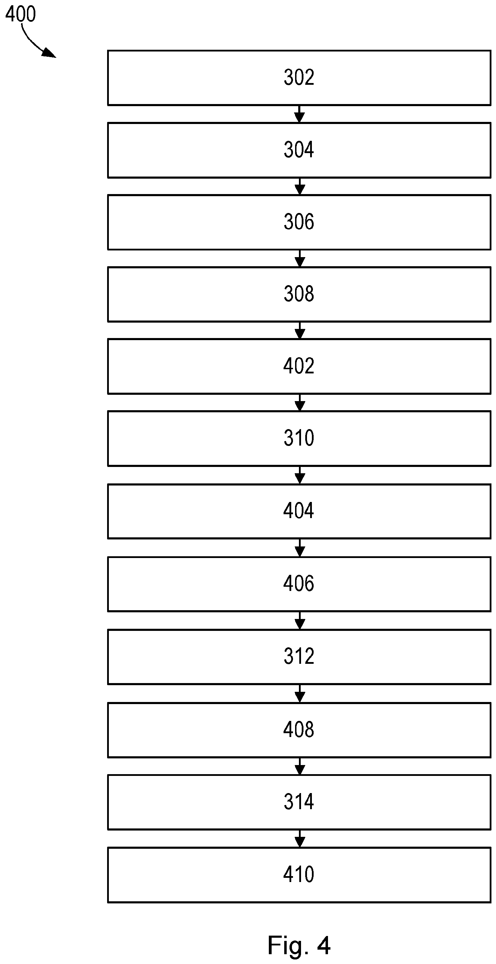

Fig. 4 is a further example of a method 400 for determining a level of interaction experienced by a subject 102. In some embodiments, the second device 104b may be associated with the body of a second subject 102b. In some examples, method 400 may comprise obtaining 402 second relative orientation data indicative of an orientation of the second device 104b relative to a facing direction of the second subject 102b; determining 408, based on the obtained second relative orientation data and the second orientation data, an indication of an absolute orientation of the second subject 102b with respect to a second reference frame; and determining 410, based on the first location data, the second location data, the indication of the absolute orientation of the first subject 102a and the indication of the absolute orientation of the second subject, a level of interaction between the first subject and the second subject.

In some embodiments, image data from a camera and/or audio data from a microphone in respect of at least one of the first subject 102a and the second device 104b (or, similarly, the first subject 102a and a second subject 102b) may be used to determine a location and/or an orientation of the first subject and/or the second device. The method 400 may comprise receiving 404 at least one of: image data in respect of at least one of the first subject 102a and the second device 104b, from a camera; and audio data in respect of at least one of the first subject and the second device, from a microphone; wherein determining the level of interaction is further based on at least one of the image data and the audio data. Advantageously, camera and/or microphone data may increase the accuracy of a determination of a level of interaction of a subject 102 and a device 104, or of a pair of subjects. One or more cameras and/or microphones may be located within a facility, such as a care home (e.g. the one or more cameras and/or microphones may be fitted to a ceiling, a wall, positioned on a stand, or the like). In some examples, one or more cameras and/or microphones may be associated with (e.g. located within or on) a device 104 and/or a receiver 108. Determining a level of interaction between a subject 102 and a device 104, or between a pair of subjects, may be further based on at least one of the image data and the audio data. The image and/or audio data may be transmitted to a processing apparatus 110 in the same way as for the location and/or orientation data of a device 104, as described previously. In some examples, camera data may be used to identify a subject 102 and determine a proximity of the subject to a second device 104b or to a second subject, an orientation of the subject (e.g. whether they are sitting, standing, lying down, or the like), and/or whether they appear to be interacting with the second device and/or the second subject based on their facial expressions, bodily gestures (e.g. hand gestures), or the like. In some examples, a microphone may be used to detect speech audio signals. In some examples, microphone data corresponding to a first subject 102a may be used in the determination of a level of interaction of the first subject and a second device 104b or a second subject 102b; for example, a microphone may be installed within a first device but not in a second device. In other examples, microphone data corresponding to both a first subject 102a and a second subject 102b (e.g. a microphone located in both a first device 104a and a second device 104b associated with the first subject and second subject, respectively) may be used infer a level of interaction of the subjects. If microphone data is obtained for both the first device 104a and the second device 104b, the accuracy of the determination of a level of interaction of the two subjects 102 may be relatively higher.

In some embodiments, a social interaction detection system may be used to selectively activate or de-activate a sensor within the system (e.g. a microphone recording, a magnetometer measurement, or the like). For example, the processing apparatus 110 may be configured to activate or de-activate sensor measurements, or to take into account when determining a level of interaction between a subject 102 and a device 104 a subset of the available or recorded measurements (e.g. some measurements may be less reliable than others during any given measurement period, or if certain measurements are not available).

Determining a level of interaction may further comprise determining a duration for which a subject 102 and a device 104, or the first subject 102a and the second subject 102b, are within a threshold proximity of one another and/or determining that the direction in which the first subject is facing (determined by using, for example, the orientation of the first device with respect to a first reference frame) is within a defined angular range of the direction in which the second subject is facing. For example, the first subject 102a and the second subject 102b (or the first subject 102a and the second device 104a) may need to be within a threshold proximity (e.g. a predefined distance such as less than 1 metre, less than 2 metres, within the same room of a facility as determined using, for example, a floor plan of the facility, or the like), and may need to be within the threshold proximity for a predefined duration (e.g. 1 second, 5 seconds, 10 seconds, 1 minute, 10 minutes, or the like). The direction in which the first subject 102a is facing may need to be within a defined angular range of the direction in which the second subject 102b is facing. For example, a level of interaction of the first subject 102a and second subject 102b may depend on whether the second subject is in view of the first subject and/or whether the first subject is in view of the second subject. The level of interaction of the first subject 102a and second subject 102b may depend on whether the first subject is within the view of the second subject and/or the whether the second subject is within the view of the first subject. For example, if the first subject 102a is within the second subject's 102b direct line of sight (e.g. the second subject is looking directly at the first subject), then the level of interaction between the first subject and the second subject may be relatively higher than if, for example, the first subject is in the peripheral view of the second subject.

In some embodiments, method 400 may comprise obtaining 406 a floor plan including an indication of boundaries 112 of a facility in which the first subject 102a is located, wherein determining the level of interaction may be further based on the indication of boundaries in the floor plan.

In some embodiments, any of the above-mentioned features of the invention may be applied to a connected, multi-user environment, comprising a network of wearable sensors. For example, pairwise information (e.g. a proximity of a first device 104a and a second device 104b derived using a location of the first device and the second device) may be determined for each pair of devices within a multi-device environment. In a situation where there are more than two subjects present, multiple sensor readings (e.g. location sensors using Bluetooth (RTM), magnetometers, or the like), can be shared across the associated devices to reduce noise. For example, having more sensor measurements (e.g. location measurements via trilateration) may allow for a more accurate determination of a location of a device 104.

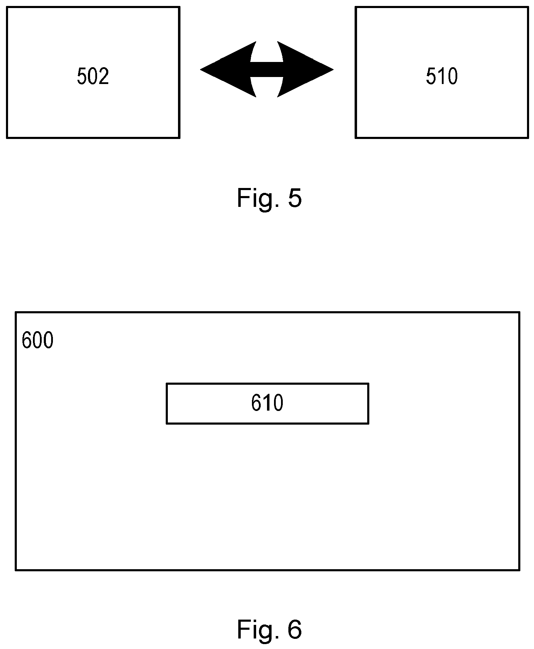

Another aspect of the invention relates to a computer program product. Fig. 5 a schematic illustration of a non-transitory computer readable medium 502 in communication with a processor 510. According to some embodiments, a computer program product comprises a non-transitory computer readable medium 502, the computer readable medium having computer readable code embodied therein, the computer readable code being configured such that, on execution by a suitable computer or processor 510, the computer or processor is caused to perform steps of the methods disclosed herein.

Fig. 6 is a schematic illustration of an example of an apparatus 600 comprising a processing apparatus 610. The processing apparatus 610 is configured to perform any of the method steps disclosed herein.

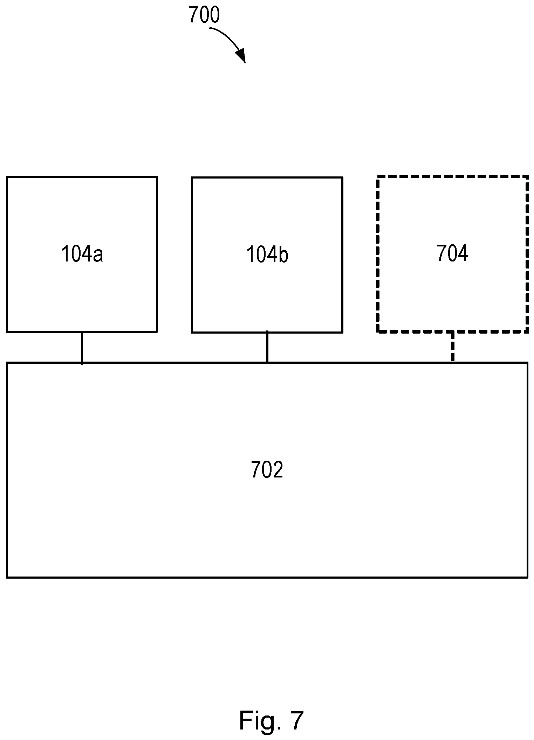

Another aspect of the invention relates to a system. Fig. 7 is a schematic illustration of an example of a system 700, which may comprise or be similar to the system 100 discussed above. The system 700 comprises a first device 104a configured to be worn on the body of a first subject. The system 700 further comprises a second device 104b. The first and second devices may comprise the devices discussed above. The system 700 further comprises a processing apparatus 702 configured to receive first location data indicative of a location of the first device relative to at least one reference location; obtain first relative orientation data indicative of an orientation of the first device relative to a facing direction of the first subject; receive first orientation data indicative of an orientation of the first device relative to a first reference frame; receive second location data indicative of a location of the second device relative to at least one reference location; receive second orientation data indicative of an orientation of the second device relative to a second reference frame; determine, based on the obtained first relative orientation data and the first orientation data, an indication of an absolute orientation of the first subject with respect to the first reference frame; and determine, based on the first location data, the second location data, the second orientation data and the indication of the absolute orientation of the first subject, a level of interaction between the first subject and the second device.

In some embodiments, the system 700 may further comprise a sensor 704 configured to capture at least one of image data and audio data in respect of at least one of the first subject and the second device. The processing apparatus 702 may be configured to determine the level of interaction further based on at least one of the image data and the audio data.

The first device 104a may, in some embodiments, comprise a first magnetometer. The second device 104b may comprise a second magnetometer. The first orientation data and the second orientation data may be acquired using the first magnetometer and the second magnetometer respectively.

The second device 104b may be configured to be worn on the body of a second subject. The processing apparatus 702 may be configured to obtain second relative orientation data indicative of an orientation of the second device relative to a facing direction of the second subject; determine, based on the obtained second relative orientation data and the second orientation data, an indication of an absolute orientation of the second subject with respect to a second reference frame; and determine, based on the first location data, the second location data, the indication of the absolute orientation of the first subject and the indication of the absolute orientation of the second subject, a level of interaction between the first subject and the second subject.

The processor 110, 510, 702 can comprise one or more processors, processing units, multi-core processors or modules that are configured or programmed to control the apparatus 600 in the manner described herein. In particular implementations, the processor 110, 510, 702 can comprise a plurality of software and/or hardware modules that are each configured to perform, or are for performing, individual or multiple steps of the method described herein.

The term "module", as used herein is intended to include a hardware component, such as a processor or a component of a processor configured to perform a particular function, or a software component, such as a set of instruction data that has a particular function when executed by a processor.

It will be appreciated that the embodiments of the invention also apply to computer programs, particularly computer programs on or in a carrier, adapted to put the invention into practice. The program may be in the form of a source code, an object code, a code intermediate source and an object code such as in a partially compiled form, or in any other form suitable for use in the implementation of the method according to embodiments of the invention. It will also be appreciated that such a program may have many different architectural designs. For example, a program code implementing the functionality of the method or system according to the invention may be sub-divided into one or more sub-routines. Many different ways of distributing the functionality among these sub-routines will be apparent to the skilled person. The sub-routines may be stored together in one executable file to form a self-contained program. Such an executable file may comprise computer-executable instructions, for example, processor instructions and/or interpreter instructions (e.g. Java interpreter instructions). Alternatively, one or more or all of the sub-routines may be stored in at least one external library file and linked with a main program either statically or dynamically, e.g. at run-time. The main program contains at least one call to at least one of the sub-routines. The sub-routines may also comprise function calls to each other. An embodiment relating to a computer program product comprises computer-executable instructions corresponding to each processing stage of at least one of the methods set forth herein. These instructions may be sub-divided into sub-routines and/or stored in one or more files that may be linked statically or dynamically. Another embodiment relating to a computer program product comprises computer-executable instructions corresponding to each means of at least one of the systems and/or products set forth herein. These instructions may be sub-divided into sub-routines and/or stored in one or more files that may be linked statically or dynamically.

The carrier of a computer program may be any entity or device capable of carrying the program. For example, the carrier may include a data storage, such as a ROM, for example, a CD ROM or a semiconductor ROM, or a magnetic recording medium, for example, a hard disk. Furthermore, the carrier may be a transmissible carrier such as an electric or optical signal, which may be conveyed via electric or optical cable or by radio or other means. When the program is embodied in such a signal, the carrier may be constituted by such a cable or other device or means. Alternatively, the carrier may be an integrated circuit in which the program is embedded, the integrated circuit being adapted to perform, or used in the performance of, the relevant method.

Variations to the disclosed embodiments can be understood and effected by those skilled in the art in practicing the principles and techniques described herein, from a study of the drawings, the disclosure and the appended claims. In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measures cannot be used to advantage. A computer program may be stored or distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

## Claims

1.  A computer-implemented method (300) for determining a level of interaction experienced by a subject (102), the method comprising:

    receiving (302) first location data indicative of a location of a first device (104a) relative to at least one reference location, the first device being positioned about the body of a first subject (102a);
    obtaining (304) first relative orientation data indicative of an orientation of the first device (104a) relative to a facing direction of the first subject (102a);
    receiving (306) first orientation data indicative of an orientation of the first device (104a) relative to a first reference frame;
    receiving (308) second location data indicative of a location of a second device (104b) relative to at least one reference location;
    receiving (310) second orientation data indicative of an orientation of the second device (104b) relative to a second reference frame;
    determining (312), based on the obtained relative orientation data and the first orientation data, an indication of an absolute orientation of the first subject (102a) with respect to the first reference frame; and
    determining (314), based on the first location data, the second location data, the second orientation data and the indication of the absolute orientation of the first subject (102a), a level of interaction between the first subject and the second device (104b).

2.  A method (300) according to claim 1, wherein the second device (104b) is associated with the body of a second subject (102b); the method further comprising:

    obtaining (402) second relative orientation data indicative of an orientation of the second device (104b) relative to a facing direction of the second subject (102b);
    determining (408), based on the obtained second relative orientation data and the second orientation data, an indication of an absolute orientation of the second subject (102b) with respect to the second reference frame; and
    determining (410), based on the first location data, the second location data, the indication of the absolute orientation of the first subject (102a) and the indication of the absolute orientation of the second subject (102b), a level of interaction between the first subject and the second subject.

3.  A method (300) according to claim 1 or claim 2, further comprising:

    receiving (404) at least one of: image data in respect of at least one of the first subject (102a) and the second device (104b), from a camera; and audio data in respect of at least one of the first subject and the second device, from a microphone;
    wherein determining (314, 410) the level of interaction is further based on at least one of the image data and the audio data.

4.  A method (300) according to any of the preceding claims, wherein the first location data is indicative of a location of the first device (104a) relative to at least one of: a receiver of a localisation system; and the second device (104b); and
    wherein the second location data is indicative of a location of the second device relative to at least one of: a receiver of the localisation system; and the first device (104a).

5. A method (300) according to any of the preceding claims, wherein the first relative orientation data comprises data acquired in respect of an orientation of the first device (104a) relative to the facing direction of the first subject (102a) over a historic period of time.

6. A method (300) according to any of the preceding claims, further comprising:

obtaining (406) a floor plan including an indication of boundaries of a facility in which the first subject (102a) is located;
wherein determining (314, 410) the level of interaction is further based on the indication of boundaries in the floor plan.

7. A method (300) according to any of claims 2 to 6, wherein determining (410) a level of interaction comprises determining a duration for which: i) the first subject (102a) and the second subject (102b) are within a threshold proximity of one another; and ii) the direction in which the first subject is facing is within a defined angular range of the direction in which the second subject is facing.

8. A method (300) according to any of the preceding claims, wherein the first relative orientation data comprises a model describing a relationship between the orientation of the first device (104a) and the facing direction of the first subject (102a).

9. A method (300) according to any of the preceding claims, wherein the first location data and the second location data are determined using at least one of a Bluetooth-based localisation system and a WiFi-based localisation system.

10. A computer program product comprising a non-transitory computer readable medium (502), the computer readable medium having computer readable code embodied therein, the computer readable code being configured such that, on execution by a suitable computer or processor (510), the computer or processor is caused to perform the method of any of the preceding claims.

11. An apparatus (600) for determining a level of interaction experienced by a subject 102, the apparatus comprising:
a processor (610) configured to:

receive (302) first location data indicative of a location of a first device (104a) relative to at least one reference location, the first device being associated with the body of a first subject (102a);
obtain (304) first relative orientation data indicative of an orientation of the first device relative to a facing direction of the first subject;
receive (306) first orientation data indicative of an orientation of the first device relative to a first reference frame;
receive (308) second location data indicative of a location of a second device (104b) relative to at least one reference location;
receive (310) second orientation data indicative of an orientation of the second device relative to a second reference frame;
determine (312), based on the obtained first relative orientation data and the first orientation data, an indication of an absolute orientation of the first subject with respect to the first reference frame; and
determine (314), based on the first location data, the second location data, the second orientation data and the indication of the absolute orientation of the first subject, a level of interaction between the first subject and the second device (104b).

12. A system (700) comprising:

a first device (104a) configured to be worn on the body of a first subject (102a);
a second device (104b);
processing apparatus (702) configured to:

receive (302) first location data indicative of a location of the first device (104a) relative to at least one reference location;
obtain (304) first relative orientation data indicative of an orientation of the first device relative to a facing direction of the first subject;

receive (306) first orientation data indicative of an orientation of the first device relative to a first reference frame;

receive (308) second location data indicative of a location of the second device (104b) relative to at least one reference location;

receive (310) second orientation data indicative of an orientation of the second device relative to a second reference frame;

determine (312), based on the obtained first relative orientation data and the first orientation data, an indication of an absolute orientation of the first subject with respect to the first reference frame; and

determine (314), based on the first location data, the second location data, the second orientation data and the indication of the absolute orientation of the first subject, a level of interaction between the first subject and the second device.

13. A system (700) according to claim 12, further comprising:

a sensor (704) to capture at least one of image data and audio data in respect of the at least one of the first subject (102a) and the second device (104b);

wherein the processing apparatus (702) is configured to:

determine (314, 410) the level of interaction further based on at least one of the image data and the audio data.

14. A system (700) according to claim 12 or claim 13, wherein the first device (104a) comprises a first magnetometer; wherein the second device (104b) comprises a second magnetometer; and wherein the first orientation data and the second orientation data are acquired using the first magnetometer and the second magnetometer respectively.

15. A system (700) according to any of claims 12 to 14, wherein the second device (104b) is configured to be worn on the body of a second subject (102b); and

wherein the processing apparatus (702) is configured to:

obtain (402) second relative orientation data indicative of an orientation of the second device relative to a facing direction of the second subject;

determine (408), based on the obtained second relative orientation data and the second orientation data, an indication of an absolute orientation of the second subject with respect to the second reference frame; and

determine (410), based on the first location data, the second location data, the indication of the absolute orientation of the first subject and the indication of the absolute orientation of the second subject, a level of interaction between the first subject and the second subject.

100

108d

104e

102e

112

108c

104d

102d

Fig. 1

104c

102c

104f

104b

102b

106

110

108b

108a

102a

104a

Fig. 2

300

```
┌─────────────────────────────────┐
│              302                │
└─────────────────────────────────┘
                 │
                 ▼
┌─────────────────────────────────┐
│              304                │
└─────────────────────────────────┘
                 │
                 ▼
┌─────────────────────────────────┐
│              306                │
└─────────────────────────────────┘
                 │
                 ▼
┌─────────────────────────────────┐
│              308                │
└─────────────────────────────────┘
                 │
                 ▼
┌─────────────────────────────────┐
│              310                │
└─────────────────────────────────┘
                 │
                 ▼
┌─────────────────────────────────┐
│              312                │
└─────────────────────────────────┘
                 │
                 ▼
┌─────────────────────────────────┐
│              314                │
└─────────────────────────────────┘
```

Fig. 3

400

```
┌─────────────────────────────────┐
│               302               │
└─────────────────────────────────┘
                 │
                 ▼
┌─────────────────────────────────┐
│               304               │
└─────────────────────────────────┘
                 │
                 ▼
┌─────────────────────────────────┐
│               306               │
└─────────────────────────────────┘
                 │
                 ▼
┌─────────────────────────────────┐
│               308               │
└─────────────────────────────────┘
                 │
                 ▼
┌─────────────────────────────────┐
│               402               │
└─────────────────────────────────┘
                 │
                 ▼
┌─────────────────────────────────┐
│               310               │
└─────────────────────────────────┘
                 │
                 ▼
┌─────────────────────────────────┐
│               404               │
└─────────────────────────────────┘
                 │
                 ▼
┌─────────────────────────────────┐
│               406               │
└─────────────────────────────────┘
                 │
                 ▼
┌─────────────────────────────────┐
│               312               │
└─────────────────────────────────┘
                 │
                 ▼
┌─────────────────────────────────┐
│               408               │
└─────────────────────────────────┘
                 │
                 ▼
┌─────────────────────────────────┐
│               314               │
└─────────────────────────────────┘
                 │
                 ▼
┌─────────────────────────────────┐
│               410               │
└─────────────────────────────────┘
```

Fig. 4

EP 3 961 525 A1

Fig. 5

Fig. 6

21

Fig. 7

Europäisches
Patentamt

European
Patent Office

Office européen
des brevets

# EUROPEAN SEARCH REPORT

Application Number

EP 20 19 3630

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GEORG GROH ET AL: "Detecting Social Situations from Interaction Geometry", SOCIAL COMPUTING (SOCIALCOM), 2010 IEEE SECOND INTERNATIONAL CONFERENCE ON, IEEE, PISCATAWAY, NJ, USA, 20 August 2010 (2010-08-20), pages 1-8, XP031767394, ISBN: 978-1-4244-8439-3 * the whole document * | 1-15 | INV. G06Q10/04 G06Q30/02 |

-----

TECHNICAL FIELDS
SEARCHED (IPC)

G06Q

The present search report has been drawn up for all claims

| Place of search | Date of completion of the search | Examiner |
|---|---|---|
| Munich | 27 January 2021 | Reino, Bernardo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)